# EUROPÄISCHE PATENTSCHRIFT

(11) **EP 3 471 992 B1**
(45) Veröffentlichungstag und Bekanntmachung des Hinweises auf die Patenterteilung: **18.03.2020**
(21) Anmeldenummer: 17730377.3
(22) Anmeldetag: 25.04.2017
(51) Int. Cl.: B60L 53/14, B60L 53/16, B60L 53/31, B60L 53/18, B60L 53/10

(54) **VORRICHTUNG, VERFAHREN UND SYSTEM ZUR ÜBERWACHUNG EINES LADEKABELS AN EINER LADESTATION**
DEVICE, METHOD AND SYSTEM FOR MONITORING A CHARGING CABLE ON A CHARGING STATION
DISPOSITIF, PROCÉDÉ ET SYSTÈME PERMETTANT DE SURVEILLER UN CÂBLE DE CHARGE À UNE STATION DE CHARGE

(30) Priorität: 17.06.2016 DE 102016111094
(43) Veröffentlichungstag der Anmeldung: 24.04.2019
(73) Patentinhaber: Innogy SE, 45128 Essen (DE)
(72) Erfinder: HELNERUS, Stefan, 59821 Arnsberg (DE); WAFFNER, Jürgen, 45307 Essen (DE)
(74) Vertreter: Cohausz & Florack
(86) Internationale Anmeldenummer: PCT/EP2017/059695
(87) Internationale Veröffentlichungsnummer: WO 2017/215821

(56) Entgegenhaltungen:
- DE-A1-102009 016 895
- JP-A- 2010 264 871
- JP-A- 2013 051 827
- US-A1- 2014 067 680

## Beschreibung

Der Gegenstand betrifft eine Vorrichtung, ein Verfahren sowie ein System zur Überwachung eines Ladekabels an einer Ladestation.

Ladestationen für Elektrofahrzeuge sind in zwei Varianten denkbar. In einer ersten Variante hat die Ladestation lediglich ein Aufnahmemittel, insbesondere eine Buchse, für einen Stecker eines Ladekabels. Das Ladekabel wird vom Nutzer des Elektrofahrzeugs mitgeführt. Für den Ladevorgang wird der Stecker des Ladekabels an die Ladestation bzw. die Buchse der Ladestation angesteckt. Nach dem Ende des Ladevorgangs zieht der Nutzer das Ladekabel von der Ladestation ab und nimmt es wieder an sich. Hierbei besteht nicht die Gefahr, dass das Ladekabel außerhalb eines Ladevorgangs auf den Bürgersteig liegt und somit ein Stolperhindernis bildet.

In einer zweiten Variante ist das Ladekabel fest an der Ladestation angeschlagen. D.h., dass das Ladekabel dauerhaft mit der Ladestation verbunden ist. Am Ende des Ladekabels ist ein Stecker oder eine Buchse vorgesehen, der in eine Aufnahme eines Fahrzeugs gesteckt werden kann. Für einen Ladevorgangs nimmt der Nutzer eines Elektrofahrzeugs das Ladekabel und verbindet dieses mit seinem Fahrzeug. Nach dem Ende des Ladevorgangs kann jedoch bisher nicht sichergestellt werden, dass das an der Ladestation verbleibende Ladekabel geordnet zurück gelegt wird und nicht ungeordnet auf dem Bürgersteig liegen bleibt und somit dort ein Stolperhindernis bildet.

Aus der JP2013-51827 ist eine Ladestation bekannt, bei der ein Ladekabel in einer Schlaufe an einem Ladekabelhalter aufbewahrt werden kann. Das Ladekabel wird in dem Ladekabelhalter durch eine Überwachungseinrichtung überwacht.

Automatische Aufrollvorrichtungen, die das Ladekabel in die Ladestation zurückziehen, sind aufwendig und fehleranfällig. Dies ist insbesondere bei einem massenhaften Einsatz von Ladestationen unvorteilhaft, da der Wartungsaufwand unverhältnismäßig groß ist.

Es muss daher möglichst verhindert werden, dass ein fest angeschlagenes Ladekabel nach dem Ladevorgang ungeordnet an der Ladestation liegt und ein Stolperhindernis bildet. Es sollte sichergestellt sein, dass das Ladekabel nach dem Ladevorgang aufgewickelt um eine Kabelhalterung liegt. Dies stellt auch sicher, dass das Ladekabel weniger beschädigt wird, insbesondere bei einem Überfahren des Ladekabels mit einem Fahrzeug oder dergleichen.

Aus diesem Grunde lag dem Gegenstand die Aufgabe zugrunde, eine Vorrichtung sowie ein Verfahren und ein System zur Verfügung zu stellen, bei dem fest angeschlagene Ladekabel von Ladestationen kein Stolperhindernis bilden.

Diese Aufgabe wird durch eine Ladestation nach Anspruch 1, ein Verfahren nach Anspruch 11 sowie ein System nach Anspruch 15 gelöst.

Die Erfinder haben erkannt, dass es möglich ist, mit Hilfe von Überwachungseinrichtungen die Lage des Ladekabels an der Ladestation zu überwachen. Hierzu wird eine Ladestation, an der ein Ladekabel fest angeschlagen ist, mit einem Ladekabelhalter und einer Überwachungseinrichtung ausgestattet. Der Ladekabelhalter ist ein mechanisches Aufnahmemittel für ein Ladekabel. Insbesondere ist der Ladekabelhalter eine bogen- oder halbkreisförmige Aufnahme für ein Ladekabel. Der Ladekabelhalter ist dazu gebildet, dass Ladekabel in mehreren Schlaufen bzw. Wicklungen aufzunehmen.

Um sicherzustellen, dass das Ladekabel tatsächlich um den Ladekabelhalter gewickelt ist, wird vorgeschlagen, dass eine zur Überwachung der Lage des Ladekabels an der Ladestation eingerichtete Überwachungseinrichtung vorgesehen ist. Die Überwachungseinrichtung überwacht, ob das Ladekabel in zumindest einer Schlaufe um den Ladekabelhalter gelegt ist.

Ein Ladevorgang ist in der Regel einem Nutzer zuzuordnen. Wenn der Ladevorgang beendet ist, ist der Nutzer angehalten, das Ladekabel um den Ladekabelhalter in zumindest einer Schlaufe, vorzugsweise mehreren Schlaufen zu wickeln. Insbesondere ist die Anzahl der Schlaufen abhängig von der Länge des Ladekabels und es muss sichergestellt sein, dass das Ladekabel nicht an seinem losen Ende frei auf dem Boden liegen bleibt. Wird nun mit Hilfe der Überwachungseinrichtung überwacht, ob das Ladekabel in einer entsprechenden Anzahl an Schlaufen um den Ladekabelhalter gelegt wurde oder nicht, kann festgestellt werden, ob der Nutzer der Ladestation das Ladekabel tatsächlich auch ordnungsgemäß zurückgelegt hat.

Ist dies nicht der Fall, kann der Nutzer gegebenenfalls darüber informiert werden. Bei mehrmaligen Verstößen kann der Nutzer beispielsweise von dem Ladesystem ausgeschlossen werden oder mit einem Malus belegt werden. Es ist aber auch möglich, dass ein Belohnungssystem eingeführt wird, insbesondere kann es möglich sein, dass der abgerechnete Energiepreis davon abhängig ist, ob der Nutzer am Ende des Ladevorgangs das Ladekabel um den Ladekabelhalter gelegt hat oder nicht. Abhängig von einem Signal der Überwachungseinrichtung kann ein Preissignal variiert werden, welches den Preis für die bezogene Energiemenge bestimmt. Insbesondere kann ein Preisabzug erfolgen, wenn die Überwachungseinrichtung ein ordnungsgemäß zurückgelegtes Ladekabel gemeldet hat.

Andere Bonussysteme sind auch denkbar. Zum Beispiel kann eine Anzahl an erfolgreichen Vorgängen gezählt werden, in denen das Ladekabel zurückgelegt wurde und bei einer gewissen Anzahl kann ein Bonus ausgekehrt werden.

Mit Hilfe der gegenständlichen Ladestation ist es nunmehr möglich festzustellen, ob am Ende eines Ladevorgangs das Ladekabel korrekt auf den Ladekabelhalter gelegt wurde oder nicht. Dies ermöglicht es, die Sicherheit an den Ladestationen zu erhöhen, in dem die Nutzer durch geeignete Bonus- oder Malussysteme dazu angehalten werden können, das Ladekabel korrekt zurückzulegen. Die Anzahl der Vorgänge, in denen das Ladekabel ungeordnet auf dem Boden um die Ladestation herum liegt, kann verringert werden. Die Überwachung, ob das Ladekabel in zumindest einer Schlaufe um den Ladekabelhalter gelegt ist, kann in vielfacher Weise erfolgen. Insbesondere kann eine Überwachung funktechnisch, wiegetechnisch, magnetisch, optisch, elektrisch, elektronisch oder dergleichen erfolgen. Verschiedene Varianten von Überwachungseinrichtungen können einzeln oder in Kombination miteinander zum Einsatz kommen, um die Lage des Ladekabels an dem Ladekabelhalter bestimmen zu können.

Gemäß einem nicht beanspruchten Beispiel wird vorgeschlagen, dass die Überwachungseinrichtung eine drahtlose Leseeinrichtung eingerichtet für eine Nahfeldkommunikation aufweist. Eine Nahfeldkommunikation kann insbesondere nach dem NFC-Standard oder dem Bluetooth-Standard oder einem geeigneten anderen Standard, der mit Hilfe von magnetischen oder elektromagnetischen Feldern operiert, erfolgen. Mit Hilfe der Leseeinrichtung kann zumindest eine Nahfelderkennung eines an dem Ladekabel angeordneten Erkennungsmittels erfolgen. Ein Erkennungsmittel kann ein passives Erkennungsmittel sein, welches durch ein Lesefeld der Leseeinrichtung aktiviert ist und insbesondere entweder das Lesefeld bzw. die Lesefeldstärke entsprechend seiner Kennung verändert oder eine eigene Kennung in einem Sendefeld, insbesondere auf einer von dem Lesefeld verschiedenen Sendefrequenz aussendet.

An dem Ladekabel können die Erkennungsmittel insbesondere in oder an der Isolation angeordnet sein. Mit Hilfe der Erkennungsmittel und der Leseeinrichtung ist es möglich, zu überwachen, ob das Ladekabel in zumindest einer Schlaufe um den Ladekabelhalter gewickelt ist. Dadurch, dass die Leseeinrichtung einen bestimmten räumlichen Bereich erfasst (und auf diesen Bereich beschränkt sein kann) und überprüft, ob in diesem Bereich die Erkennungsmittel gelesen werden können, kann festgestellt werden, ob das Ladekabel mit seinen Erkennungsmitteln in eben diesem Bereich ist und somit in einer bestimmten Position an der Ladestation angeordnet ist. Der Bereich kann definiert sein, so dass nur dann, wenn das Ladekabel über den Ladekabelhalter gewickelt ist, die Erkennungsmittel in dem entsprechenden Bereich angeordnet sind. Somit kann sichergestellt sein, dass die Leseeinrichtung die Erkennungsmittel dann liest, wenn das Ladekabel richtig auf den Ladekabelhalter gewickelt ist.

Gemäß einem Ausführungsbeispiel wird vorgeschlagen, dass die Überwachungseinrichtung eine Wiegeeinrichtung aufweist. Mit Hilfe der Wiegeeinrichtung kann das Gewicht des Ladekabelhalters zusammen mit dem gegebenenfalls daran angeordneten Ladekabel gemessen werden. Nur wenn das Ladekabel um den Ladekabelhalter gewickelt ist, übt es eine Gewichtskraft auf den Ladekabelhalter und mithin die Wiegeeinrichtung aus. Wenn das Ladekabel nicht ausreichend oft um den Ladekabelhalter gewickelt ist, kann sein freies Ende noch auf dem Boden liegen. Dieses auf dem Boden liegende Ende übt keine Gewichtskraft mehr auf den Ladekabelhalter aus. Somit ist es mit Hilfe der Wiegeeinrichtung möglich festzustellen, ob das Ladekabel vollständig um den Ladekabelhalter gewickelt ist, insbesondere ob das freie Ende des Ladekabels nicht mehr auf dem Boden liegt. Dies ist durch einen Vergleich des Messergebnisses der Wiegeeinrichtung mit einem Grenzwert möglich. Der Grenzwert kann z.B. bei einer Installation der Ladestation angelernt werden. Nur wenn das gewogene Gewicht der Ladestation über diesem Grenzwert liegt, kann auf ein aufgewickeltes Kabel geschlossen werden.

Gemäß einem Ausführungsbeispiel wird vorgeschlagen, dass die Überwachungseinrichtung eine optische Leseeinrichtung aufweist. Eine optische Leseeinrichtung kann als Lichtschranke und/oder als Bilderfassungsmittel, beispielsweise als Kamera oder Videogerät eingerichtet sein. Mit Hilfe der optischen Leseeinrichtung ist ein optisches Erkennen des an dem Ladekabelhalters angeordneten Ladekabels möglich. Beim optischen Erkennen ist es einerseits möglich, dass ein Bild des Ladekabelhalters zusammen mit dem Ladekabel erfasst wird. Insbesondere ist es möglich, dass eine Optik so eingerichtet ist, dass sie den Ladekabelhalter von oben aufnimmt. Dann kann erfasst werden, in wie vielen Windungen das Ladekabel auf dem Ladekabelhalter liegt. Dies ist z.B. dadurch möglich, dass durch eine Mustererkennung erkannt werden kann, ob in dem Bild der Ladekabelhalter oder ein Ladekabel erkannt wurde. Wird ein Ladekabel erkannt, können die einzelnen Windungen des Ladekabels voneinander z.B. durch Farbverläufe oder Kontrastverläufe unterschieden werden und somit kann festgestellt werden, wie oft das Ladekabel um den Ladekabelhalter gelegt ist. Auch können optische Erkennungsmittel an dem Ladekabel, beispielsweise in Form von Barcodes, QR Codes, farbiger Codierung oder dergleichen angebracht sein und durch die Leseeinrichtung erkannt werden. Sind die optischen Erkennungsmittel in einer zuvor definierten Position am Ladekabelhalter durch die Leseeinrichtung erkannt, so kann daraus geschlossen werden, dass das Ladekabel korrekt um den Ladekabelhalter gewickelt ist. Insbesondere ist es möglich, die optische Leseeinrichtung bei einer Installation der Ladestation anzulernen und ggf. Bilder anzulernen, die ein richtig aufgewickeltes Ladekabel zeigen. Das aktuell erfasste Bild kann mit den angelernten Bildern verglichen werden und ein Wert der Abweichung bestimmt werden. Wenn der Wert der Abweichung unterhalb eines Grenzwertes liegt, kann dies als Hinweis gewertet werden, dass das Ladekabel korrekt um den Ladekabelhalter gewickelt ist. Somit ist mit Hilfe der optischen Leseeinrichtung eine Überwachung möglich, ob das Ladekabel in zumindest einer Schlaufe um den Ladekabelhalter gewickelt ist.

Gemäß einem nicht beanspruchten Beispiel wird vorgeschlagen, dass die Überwachungseinrichtung einen Näherungssensor aufweist. Ein Näherungssensor kann beispielsweise zum Erkennen einer Bewegung des an dem Ladekabelhalter angeordneten Ladekabels eingerichtet sein. Somit kann, wenn der Näherungssensor unmittelbar an dem Ladekabelhalter angeordnet ist beispielsweise festgestellt werden, wenn das Ladekabel auf den Ladekabelhalter gelegt wird. Das Ladekabel muss, wenn es auf den Ladekabelhalter gelegt wird, an dem Näherungssensor vorbeigeführt werden. Durch eine geeignete Anordnung eines oder zweier Näherungssensoren kann die Richtung der Bewegung detektiert werden. Ist eine Bewegung des Ladekabels zum Ladekabelhalter hin detektiert worden, so kann darauf geschlossen werden, dass das Ladekabel in einer Windung um den Ladekabelhalter gelegt wurde. Die Anzahl der Windungen bzw. Wicklungen, die das Ladekabel um den Ladekabelhalter gelegt werden muss, kann definiert sein. Der Näherungssensor kann feststellen, wie oft das Ladekabel an dem Näherungssensor vorbeigeführt und in Richtung des Ladekabelhalters bewegt wurde. Daraus lässt sich schließen, ob das Ladekabel in zumindest einer Schlaufe um den Ladekabelhalter gewickelt wurde.

Wie bereits erläutert, kann die Überwachungseinrichtung dazu eingerichtet sein, optische Erkennungsmittel an dem Ladekabel zu erfassen. Aus diesem Grunde wird gemäß einem Ausführungsbeispiel vorgeschlagen, dass an dem Ladekabel zumindest zwei optische oder elektronische Erkennungsmittel in Abständen zueinander angeordnet sind. Die Erkennungsmittel können dabei insbesondere BarcodesFarbcodierungen, QR Codes oder dergleichen sein. Ein Abstand zwischen jeweils zwei Erkennungsmitteln kann so sein, dass dieser der Länge des Ladekabels entspricht, die benötigt wird, um dieses genau einmal in einer Schlaufe um den Ladekabelhalter zu legen. Dies führt dazu, dass bei einer korrekten Wicklung die Erkennungsmittel jeweils in etwa an der gleichen Position im Bereich der Ladestation liegen. Mit Hilfe der Überwachungseinrichtung lassen sich somit die Erkennungsmittel in einem ganz bestimmten, definierten räumlichen Bereich erfassen.

Die Erkennungsmittel sind gemäß einem Ausführungsbeispiel durch die Überwachungseinrichtung erfassbar. Durch eine geeignete Beabstandung der Erkennungsmittel zueinander wird sichergestellt, dass diese, wenn das Ladekabel um den Ladekabelhalter gelegt ist, in etwa in einem gleichen Bereich liegen. Dadurch ist es möglich, dass die Überwachungseinrichtung dazu eingerichtet sein kann, die Erkennungsmittel in einem räumlich begrenzten Bereich zu erfassen. Durch die Begrenzung des Bereichs, in dem die Überwachungseinrichtung die Erkennungsmittel erkennen kann, kann sichergestellt sein, dass nur ein korrekt aufgewickeltes Ladekabel als solches detektiert wird.

Das Ladekabel wird in der Regel nicht nur in einer Schlaufe, sondern in zwei oder mehr Schlaufen um den Ladekabelhalter gewickelt werden. Um zu erkennen, ob das Ladekabel in einer korrekten Anzahl und in der korrekten Art und Weise um den Ladekabelhalter gewickelt wurde, kann die Überwachungseinrichtung dazu eingerichtet sein, eine Anzahl oder eine Kennung von Erkennungsmitteln zu prüfen, welche repräsentativ für das Wickeln des Ladekabels um den Ladekabelhalter sind. Hierzu werden zunächst in der Überwachungseinrichtung eine entsprechende Anzahl oder entsprechende Kennungen von Erkennungsmitteln gespeichert, die repräsentativ für das Wickeln des Ladekabels um den Ladekabelhalter sind. Während des Überprüfens, ob das Ladekabel um den Ladekabelhalter gewickelt wurde, kann die Überwachungseinrichtung prüfen, ob die erkannte Anzahl oder die erkannten Kennungen den gespeicherten entsprechen. Dabei ist zu bedenken, dass bei einer Installation der Ladestation die Anzahl und/oder die Kennungen angelernt werden können. Hierbei kann das Ladekabel in einer oder mehreren Konfigurationen um den Ladekabelhalter gelegt werden, welche als korrekt angesehen werden und in diesen Positionen können Anzahl und/oder Kennungen gelesen werden und als Vergleichswerte gespeichert werden. Bei einem positiven Vergleich der aktuellen Messwerte mit den gespeicherten Messwerten kann die Überwachungseinrichtung daraus schließen, dass das Ladekabel korrekt um den Ladekabelhalter gewickelt wurde. Ist die Anzahl nicht korrekt oder sind nicht alle Kennungen erkannt worden, kann dies ein Indiz dafür sein, dass das Ladekabel nicht korrekt um den Ladekabelhalter gewickelt wurde und die Überwachungseinrichtung kann ein entsprechendes Signal ausgeben.

Gemäß einem Ausführungsbeispiel wird vorgeschlagen, dass die Erkennungsmittel kodiert sind, derart, dass eine Ladekabel mit Hilfe der Erkennungsmittel eindeutig identifizierbar ist. Die Identifikation kann beispielsweise durch eine binäre Kodierung mit einer Prüfziffer erfolgen, so dass jedes Erkennungsmittel eineindeutig identifiziert werden kann. Eine eindeutige Identifizierung der Erkennungsmittel ermöglicht es, die Erkennungsmittel voneinander zu unterscheiden. Auch ist es möglich, dass an einer Ladestation beispielsweise zwei oder mehr Ladekabel angeschlagen sind. Um sicherzustellen, dass das Ladekabel jeweils um die richtige Ladekabelhalterung gewickelt wurde, kann in dem Erkennungsmitteln auch das Ladekabel kodiert sein. Somit kann durch die Überwachungseinrichtung überprüft werden, ob einerseits überhaupt ein Ladekabel korrekt um den Ladekabelhalter gewickelt wurde und andererseits, ob dieses Ladekabel auch das richtige Ladekabel ist und nicht gegebenenfalls das zweite Ladekabel der Ladestation, welches um einen anderen Ladekabelhalter gewickelt werden müsste. Die Kodierung kann beispielsweise durch eine binäre Kodierung mit einer Prüfziffer erfolgen, so dass jedes Ladekabel an einer Ladestation eineindeutig identifiziert werden kann.

Gemäß einem Ausführungsbeispiel wird vorgeschlagen, dass in der Ladestation eine Ladeelektronik angeordnet ist, dass die Ladeelektronik zur Erkennung eines Endes eines Ladevorgangs eingerichtet ist und dass die Ladeelektronik beim Erkennen eines Endes eines Ladevorgangs die Überwachungseinrichtung aktiviert, insbesondere für zumindest einen definierten Zeitraum.

Es ist erkannt worden, dass die Überwachungseinrichtung nicht dauerhaft aktiv sein muss. Das Erkennen, ob ein Ladekabel korrekt auf einen Ladekabelhalter gewickelt wurde, ist insbesondere dann wichtig, wenn ein Ladevorgang beendet ist. In diesem Moment zieht der Nutzer das Ladekabel von seinem Fahrzeug ab. Danach sollte er dieses dann auf den Ladekabelhalter wickeln. Somit ist ab dem Ende des Ladevorgangs die Überwachung, insbesondere für einen bestimmten Zeitraum notwendig. Es kann davon ausgegangen werden, dass der Nutzer innerhalb der nächsten Minuten das Ladekabel um den Ladekabelhalter wickeln wird. Daher kann die Ladeelektronik zunächst das Ende des Ladevorgangs erkennen, um anschließend die Überwachungseinrichtung für einen definierten Zeitraum, beispielsweise eine Minute, fünf Minuten oder fünfzehn Minuten zu aktivieren. In diesem Zeitraum überwacht die Überwachungseinrichtung, ob das Ladekabel korrekt um den Ladekabelhalter gewickelt wurde.

Gemäß einem Ausführungsbeispiel wird vorgeschlagen, dass die Überwachungseinrichtung nach Aktivierung durch die Ladeelektronik für einen definierten Zeitraum überwacht, ob das Ladekabel in zumindest einer Schlaufe um den Ladekabelhalter gewickelt ist. Es ist erkannt worden, dass das Ladekabel durch den Nutzer nur innerhalb eines gewissen Zeitraums auf den Ladekabelhalter gewickelt wird.

Ist dieser Zeitraum verstrichen, so ist mit höchster Wahrscheinlichkeit davon auszugehen, dass das Ladekabel durch den Nutzer nicht mehr auf den Ladekabelhalter gelegt werden wird. Dieser Zeitraum ist vorzugsweise eine, insbesondere zwei bis fünf Minuten nach dem Ende des Ladevorgangs. In diesem definierten Zeitraum ist die Überwachungseinrichtung aktiv und prüft, ob das Ladekabel auf den Ladekabelhalter gelegt wurde.

Nach dem Ende des Ladevorgangs ist es nicht nur wichtig zu wissen, ob das Ladekabel korrekt auf den Ladekabelhalter gelegt wurde, sondern auch, ob das Ladekabel elektrisch einwandfrei ist. Insbesondere ist der Isolationswiderstand zwischen den einzelnen Leitern des Kabels relevant für die elektrische Sicherheit des Ladekabels. Daher wird auch vorgeschlagen, dass die Überwachungseinrichtung nach Aktivierung durch die Ladeelektronik den elektrischen Zustand des Ladekabels überwacht. Hierbei kann insbesondere ein Isolationswiderstand zwischen zumindest jeweils zwei Leitern des Ladekabels gemessen werden. Ein Grenzwert kann angeben, wie hoch der Isolationswiderstand im Normalfall sein muss. Dieser Grenzwert sollte nicht unterschritten werden. Daher vergleicht die Überwachungseinrichtung den gemessenen Wert mit dem Grenzwert.

Um aus der Messung der Überwachungseinrichtung eine Aktion ableiten zu können, ist es notwendig, dass die Überwachungseinrichtung das Ergebnis der Überprüfung ausgibt. Daher wird vorgeschlagen, dass die Überwachungseinrichtung ein Bestätigungssignal ausgibt, wenn innerhalb des definierten Zeitraums detektiert wurde, dass das Ladekabel um den Ladekabelhalter gewickelt ist und/oder der elektrische Zustand des Ladekabels positiv überwacht wurde. Eine positive Überwachung kann so verstanden werden, dass die gemessenen Werte des Isolationswiderstands über dem Grenzwert liegen. Somit ist die Isolation gegeben. Dies ist ein positives Ergebnis und kann als positive Überwachung gewertet werden.

Auch ist es möglich, dass die Überwachungseinrichtung am Ende des Zeitraums, ohne dass detektiert wurde, dass das Ladekabel um den Ladekabelhalter gewickelt wurde und/oder der elektrische Zustand des Ladekabels negativ überwacht wurde, ein Fehlersignal ausgibt. Somit gibt die Überwachungseinrichtung entweder ein Bestätigungssignal oder ein Fehlersignal am Ende eines definierten Zeitraums aus. Abhängig hiervon kann beispielsweise das oben erwähnte Bonus- und/oder Malussystem ausgelöst werden.

Gemäß einem Ausführungsbeispiel wird vorgeschlagen, dass eine Aufnahmebuchse für einen Ladekabelstecker des Ladekabels in der Ladestation vorgesehen ist. Die Aufnahmebuchse dient zur mechanischen Aufnahme des Ladekabelsteckers, welcher am freien Ende des angeschlagenen Kabels angeordnet ist. In der Aufnahmebuchse ist vorzugsweise eine Prüfeinrichtung angeordnet. Die Prüfeinrichtung ist dazu eingerichtet, die Anwesenheit des Ladekabelsteckers in der Aufnahmebuchse zu prüfen. Hierzu kann die Prüfungseinrichtung insbesondere einen Endlageschalter, einen Hallsensor und/oder einen Mikroschalter aufweisen. Mit den entsprechenden Sensoren kann die Prüfeinrichtung prüfen, ob der Ladekabelstecker in die Aufnahmebuchse eingesteckt wurde.

Gemäß einem Ausführungsbeispiel wird vorgeschlagen, dass die Prüfeinrichtung beim Erkennen der Anwesenheit des Ladekabelsteckers ein Bestätigungssignal ausgibt. Das Bestätigungssignal der Prüfeinrichtung kann unterschiedlich zu dem Bestätigungssignal der Überwachungseinrichtung sein. Insbesondere können dies ein erstes und ein zweites Bestätigungssignal sein. Wenn beide Bestätigungssignale vorliegen, kann daraus geschlossen werden, dass das Ladekabel samt Ladekabelstecker korrekt an der Ladestation angeordnet wurde.

Aus diesem Grunde wird vorgeschlagen, dass ein Prozessor der Ladestation ein Bestätigungssignal der Überwachungseinrichtung und/oder ein Bestätigungssignal der Prüfeinrichtung überwacht und beim Empfangen eines oder beider Bestätigungssignale innerhalb eines definierten Zeitfensters nach dem detektierten Ende des Ladevorgangs ein Freigabesignal ausgibt. Das Freigabesignal kann dazu benutzt werden, das oben beschriebene Bonus- und/oder Malussystem zu aktivieren. Mit Hilfe des Freigabesignals kann signalisiert werden, dass das Ladekabel und gegebenenfalls auch der Ladekabelstecker korrekt an der Ladestation verstaut wurde.

Ein weiterer Aspekt ist ein Verfahren zur Überwachung eines Ladekabels an einer Ladestation nach Anspruch 11, wobei das Ladekabel an der Ladestation angeschlagen ist, bei dem mit Hilfe einer Überwachungseinrichtung überwacht wird, ob das Ladekabel in zumindest einer Schlaufe um den Ladekabelhalter gelegt ist. Insbesondere werden hierzu Überwachungseinrichtungen, wie oben beschrieben, eingesetzt. Das Verfahren eignet sich dazu, die oben beschriebene Ladestation entsprechend der obigen Beschreibung zu betreiben.

Es kann vorkommen, dass sich die Art der Wicklung von Ladestation zu Ladestation unterscheidet. Daher kann es sinnvoll sein, das Ladekabel bzw. die Wicklung des Ladekabels um den Ladekabelhalter an der Ladestation anzulernen, wie teilweise oben bereits beschrieben wurde. Daher wird vorgeschlagen, dass die Überwachungseinrichtung bei einer Montage des Ladekabels derart an das Ladekabel angelernt wird, dass Messwerte der Überwachungseinrichtung aufgenommen werden, wenn das Ladekabel in zumindest einer Schlaufe um den Ladekabelhalter gelegt wird. Die Messwerte der Überwachungseinrichtung können dann repräsentativ dafür sein, dass das Ladekabel korrekt um den Ladekabelhalter gelegt wurde. Beim Anlernen wird das Ladekabel so um den Ladekabelhalter gelegt, wie es gewünscht ist. Die Überwachungseinrichtung nimmt dann die Messwerte auf, um in der Folge gemessene Werte mit diesen angelernten Werten zu vergleichen. Dabei ist es möglich, dass beim Anlernen verschiedene Positionen oder Konfigurationen des Ladekabels an dem Ladekabelhalter angelernt werden. So ist es beispielsweise denkbar, dass unterschiedlichste Wicklungen um den Ladekabelhalter noch als korrektes Aufwickeln gewertet werden können. Insbesondere kann sich die Anzahl der Schlaufen bei den verschiedenen Konfigurationen unterscheiden. Auch kann relevant sein, dass das Ladekabel mit einem freien Ende nicht auf dem Boden liegt. Daher können verschiedene Wicklungen bei der Montage des Ladekabels an die Überwachungseinrichtung angelernt werden. Jede Wicklungskonfiguration kann eigene Messwerteergeben, die jeweils Satz von als Grenzwerten gespeichert werden können.

Im Betrieb können die aufgenommenen Messwerte als Grenzwerte für die Bestimmung, ob das Ladekabel in zumindest einer Schlaufe um den Kabelhalter gelegt ist, benutzt werden. Daher wird auch vorgeschlagen, dass die aufgenommenen Messwerte als Grenzwerte für die Bestimmung, ob das Ladekabel in zumindest einer Schlaufe um den Ladekabelhalter gelegt ist, gespeichert werden.

Gemäß einem Ausführungsbeispiel wird vorgeschlagen, dass zur Erkennung, ob das Ladekabel in zumindest einer Schlaufe um den Kabelhalter gelegt ist, Messwerte der Überwachungseinrichtung mit zuvor bestimmten Grenzwerten verglichen werden. Hierbei können Sätze von Grenzwerten für unterschiedlichste Wicklungen in der Überwachungseinrichtung gespeichert sein. Solange die gemessenen Werte innerhalb der Grenzwerte einer bestimmten Gruppe liegen, kann daraus geschlossen werden, dass das Ladekabel korrekt um den Ladekabelhalter gelegt wurde.

Mit Hilfe der optischen Erkennungsmittel ist es möglich, ein Bild der Ladestation zu erfassen. In dem Bild der Ladestation kann eine Mustererkennung derart durchgeführt werden, dass der Ladekabelhalter und das Ladekabel erkannt wird. Dann kann die Position des Ladekabels zu dem Ladekabelhalter in dem Bild bestimmt werden. Dies kann insbesondere dann relevant sein, wenn das Bild von einer externen Kamera, die außerhalb der Ladestation angeordnet ist, aufgenommen wurde. Beispielsweise kann der Nutzer zur Nutzung eines Bonussystems mit seinem mobilen Endgerät, z.B. Smartphone ein Bild der Ladestation samt Ladekabel aufnehmen. Dies kann er beispielsweise dann tun, wenn er das Ladekabel korrekt um den Ladekabelhalter gewickelt hat. In diesem Bild grenzt sich das Ladekabel als auch der Ladekabelhalter insbesondere im Kontrast und/oder der Farbe von der Ladestation ab. Mit Hilfe einer Mustererkennung ist es möglich, das Ladekabel und den Ladekabelhalter zu erfassen, in dem z.B. diese Abgrenzungen in Kontrast und/oder Farbe ausgewertet werden.

Auch ist es möglich, zu erkennen, ob das Ladekabel mit seinem freien Ende auf dem Boden liegt oder nicht. Bei der Mustererkennung und der anschließenden Auswertung des Musters kann dieses ebenfalls erneut mit Grenzwerten verglichen werden und so detektiert werden, ob die Position des Ladekabels zu dem Ladekabelhalter in einem bestimmten Grenzwert liegt. Ist dies der Fall, kann beispielsweise in einem Server ein Bonus- und/oder Malussystem ausgelöst werden.

Gemäß einem Ausführungsbeispiel wird vorgeschlagen, dass in dem Bild der Ladestation ein optisches Erkennungsmittel der Ladestation, insbesondere ein QR Code, erfasst wird. Auf der Ladestation kann ein solcher QR Code oder eine sonstige farbige Codierung aufgebracht sein und in dem Bild erfasst werden. Damit ist es möglich, dass mit Hilfe des optischen Erkennungsmittels detektiert wird, welche Ladestation auf dem Bild erfasst ist. Das optische Erkennungsmittel ist in diesem Fall beispielsweise eine externe Kamera, beispielsweise eine in einem Smartphone oder in einem sonstigen mobilen Endgerät. Der Nutzer nimmt nicht nur das Ladekabel und den Ladekabelhalter, sondern auch den Rest der Ladestation in seinem Bild auf. In diesem Fall kann die Codierung der Ladestation, beispielsweise der QR Code, in dem Bild erkannt werden und festgestellt werden, welche Ladestation der Nutzer aufgenommen hat. In einer entsprechenden mobilen Applikation kann dieses Bild dann an einen Server zur Auswertung gesendet werden.

Aus diesem Grunde wird auch vorgeschlagen, dass in einem System mit einer Ladestation nach einem der Ansprüche 2 bis 9 ein von der Ladestation abgesetztes mobiles Kommunikationsgerät eingesetzt ist. Mit Hilfe dieses mobilen Kommunikationsgerätes wird die optische Leseeinrichtung gebildet. Somit ist die Überwachungseinrichtung von der Ladestation abgesetzt.

Nachfolgend wird der Gegenstand anhand einer Ausführungsbeispiele zeigenden Zeichnung näher erläutert. In der Zeichnung zeigen:
- Fig. 1: eine Ladestation gemäß einem Ausführungsbeispiel;
- Fig. 2: eine Ladestation mit einem aufgewickelten Ladekabel;
- Fig. 3: eine Ladestation mit einem aufgewickelten Ladekabel;
- Fig. 4: eine Ladestation mit zwei getrennten Ladekabeln;
- Fig. 5: eine schematische Ansicht eines Ladekabels mit Erkennungsmitteln;
- Fig. 6: eine schematische Ansicht einer Anordnung einer Überwachungseinrichtung gemäß einem nicht beanspruchten Beispiel;

- Fig. 7: eine schematische Ansicht einer Anordnung einer Überwachungseinrichtung gemäß einem nicht beanspruchten Beispiel;

- Fig. 8: eine schematische Ansicht einer Anordnung einer Überwachungseinrichtung gemäß einem Ausführungsbeispiel;
- Fig. 9a: eine schematische Ansicht einer Anordnung einer Überwachungseinrichtung gemäß einem Ausführungsbeispiel;
- Fig. 9b: ein Bild einer Überwachungseinrichtung;
- Fig. 10: eine Ansicht eines Systems gemäß einem Ausführungsbeispiel;
- Fig. 11: eine schematische Ansicht einer Aufnahmevorrichtung für einen Ladekabelstecker.

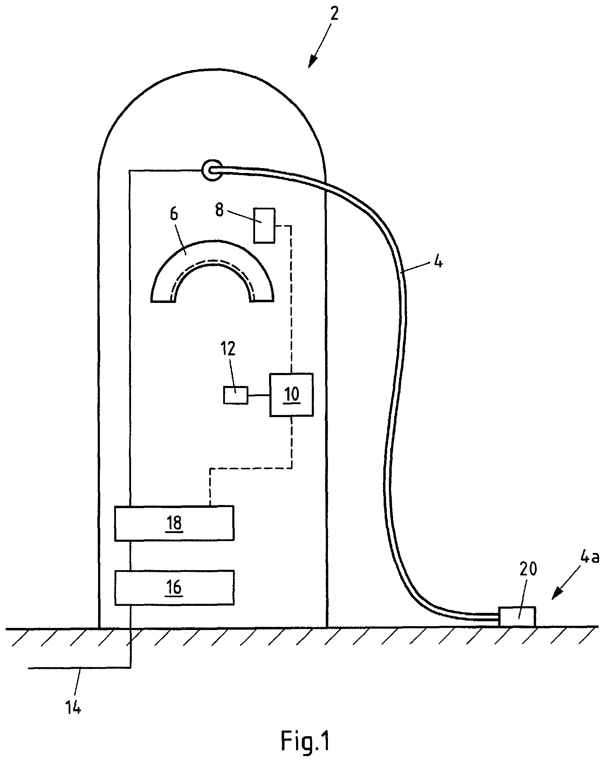

Fig. 1 zeigt eine Ladestation 2 mit einem Ladekabel 4 sowie einen Ladekabelhalter 6. In der Ladestation 2 ist eine Überwachungseinrichtung 8 angeordnet. Die Überwachungseinrichtung 8 ist in Kommunikation mit einem Prozessor 10, der aus einem Speicher 12 ein Programm laden kann, um die zuvor und nachfolgend beschriebenen Verfahren durchzuführen. Weiter kann der Speicher 12 dazu ausgelegt sein, Messwerte und Grenzwerte zu speichern, wie zuvor und nachfolgend beschrieben.

Die Ladestation 2 ist an ein elektrisches Verteilnetz 14 über eine geeignete Anschlusselektrik samt Sicherung und Schütz angeschlossen. Eine Ladeelektronik 18 übernimmt das Lademanagement, das Messen der bezogenen Energiemenge, die Kommunikation mit einem Server und alles weitere für den Ladevorgang notwendige. Die Ladeelektronik 18 überwacht insbesondere den Beginn und das Ende eines Ladevorgangs und kann dies an den Prozessor 10 mitteilen.

In der Fig. 1 ist gezeigt, dass das Ladekabel 4 nicht wie vorgesehen um den Ladekabelhalter 6 gewickelt ist, sondern mit seinem freien Ende 4a insbesondere dem Ladestecker 20 auf dem Boden liegt. Dies ist nicht nur unschön anzusehen, sondern kann auch zur Beschädigung des Ladekabels 4 oder zu Unfällen führen, wenn ein Passant über das Ladekabel 4 stolpert. Daher ist es notwendig, dass das Ladekabel 4 um den Ladekabelhalter 6 gewickelt ist. Um dies zu erreichen, sind die gegenständliche Anordnung, das gegenständliche Verfahren und das gegenständliche System vorteilhaft.

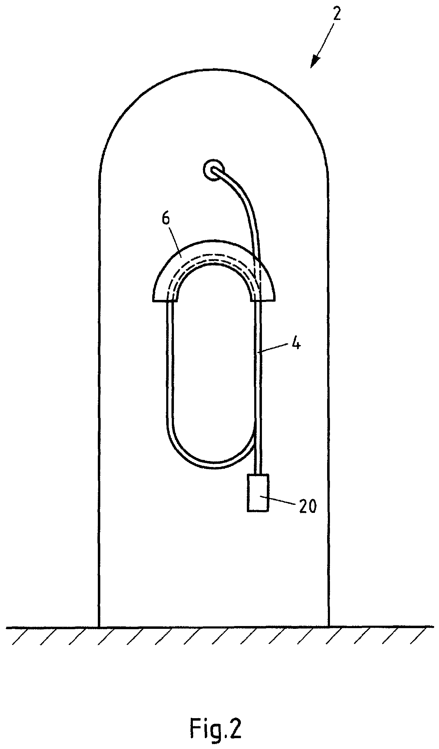

Fig. 2 zeigt eine Ladestation 2, bei der das Ladekabel 4 korrekt um den Ladekabelhalter 6 gewickelt ist. Zu erkennen ist, dass das Ladekabel 4 in einer Schlaufe um den Ladekabelhalter 6 gewickelt ist und der Ladestecker 20 frei nach unten an dem Ladekabelhalter 6 hängt.

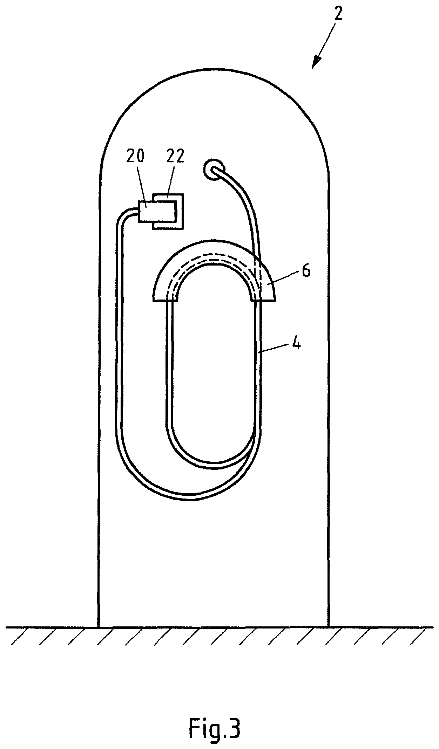

Fig. 3 zeigt ein weiteres Beispiel einer Ladestation 2, bei der das Ladekabel 4 um den Ladekabelhalter 6 gewickelt ist. Hierbei ist der Ladekabelstecker 20 noch zusätzlich in einer Halterung 22 für den Ladekabelstecker 20 angeordnet und dort befestigt.

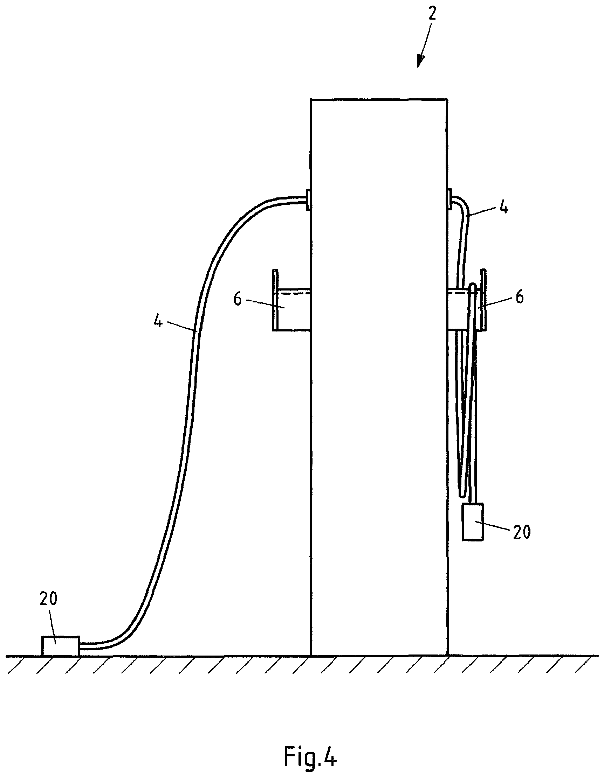

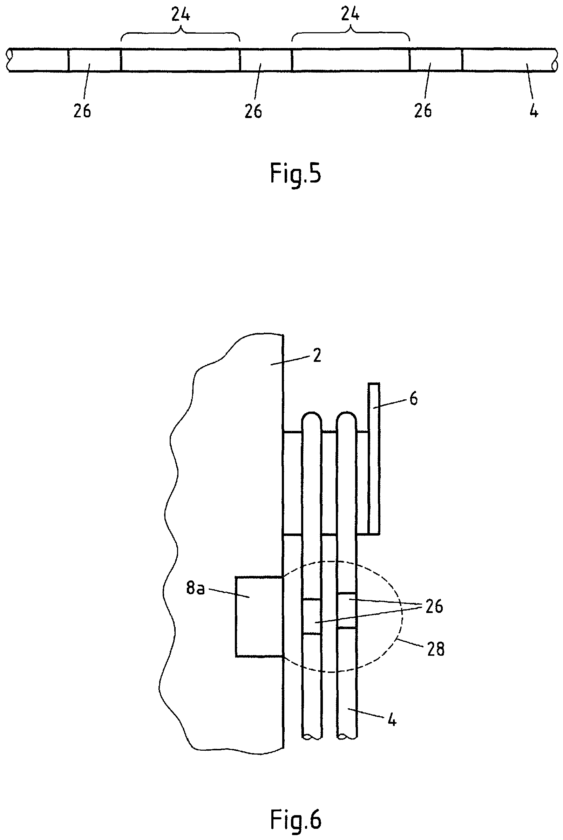

Fig. 4 zeigt eine weitere Ladestation 2, bei der zwei unterschiedliche Ladekabel 4 angeordnet sind. Das linke Ladekabel 4 ist nicht um den Ladekabelhalter 6 gewickelt, wohingegen das rechte Ladekabel 4 um den Ladekabelhalter 6 gewickelt ist. Um zu unterscheiden, welches der beiden Ladekabel 4 korrekt um den Ladekabelhalter 6 gewickelt ist, kann jedes einzelne Ladekabel 4 kodiert sein und so eindeutig identifizierbar sein. Dazu kann an dem Ladekabel 4 zumindest ein Erkennungsmittel vorgesehen sein, wie dies in der Fig. 5 dargestellt ist.

Fig. 5 zeigt schematisch ein Ladekabel 4, bei dem in Abständen 24 Erkennungsmittel 26 angeordnet sind. Die Erkennungsmittel 26 können beispielsweise eine Farbkodierung an dem Ladekabel 4 sein. Auch können die Erkennungsmittel 26 beispielsweise ein Barcode sein. Darüber hinaus ist es möglich, dass die Erkennungsmittel 26 zumindest einen Funkchip, insbesondere einen Nahfeldfunkchip, beispielsweise einen NFC- oder Bluetooth-Funkchip aufweisen. Vorteilhaft ist es, wenn die Erkennungsmittel 26 passiv sind und durch ein Erregerfeld, insbesondere von einer Leseeinrichtung aktiviert werden. Dies ist insbesondere bei NFC-Chips der Fall. Hierbei können sowohl magnetische, als auch elektromagnetische Felder verwendet werden.

Die Abstände 24 sind so gewählt, dass vorteilhafterweise bei einer vollständigen Wicklung des Ladekabels 4 um den Ladekabelhalter 6 jeweils zwei Erkennungsmittel 26 in einem in etwa gleichen Bereich angeordnet sind. Dies ist beispielhaft in der Fig. 6 gezeigt.

Fig. 6 zeigt eine Ladestation 2 mit einem Ladekabelhalter 6 und einem Ladekabel 4 in einer Seitenansicht. In der Ladestation 2 ist eine Leseeinrichtung 8a als Überwachungseinrichtung 8 angeordnet. Insbesondere ist die Leseeinrichtung 8a im Bereich des Gehäuses der Ladestation angeordnet und sendet ein Abfragefeld 28 aus. Das Abfragefeld 28 ist insbesondere ein Hochfrequenzfeld, beispielsweise ein magnetisches oder ein elektromagnetisches Feld. Durch geeignete Anordnung der Sendeantennen innerhalb der Leseeinrichtung 8a kann die Form des Abfragefeldes 28 beeinflusst werden, so dass das Abfragefeld 28 nur in einem bestimmten räumlichen Bereich Erkennungsmittel 26 abfragen kann.

In der Fig. 6 ist zu erkennen, dass das Ladekabel 4 in zwei Wicklungen um den Ladekabelhalter 6 gewickelt ist. Ferner ist zu erkennen, dass die Erkennungsmittel 26 in etwa auf gleicher Höhe im Bereich der Leseeinrichtung 8 liegen. Dies wird durch eine geeignete Wahl des Abstands 24 erreicht, der vorzugsweise der Länge genau einer Wicklung des Ladekabels 4 um den Ladekabelhalter 6 entspricht.

Durch das Abfragefeld 28 werden die Erkennungsmittel 26 ausgelesen. Hierbei kann eine Kennung der Erkennungsmittel 26 selbst ausgelesen werden und es kann beispielsweise durch die Leseeinrichtung 8a erkannt werden, dass genau zwei Erkennungsmittel 26 vorhanden sind. Hierzu sollten die Erkennungsmittel 26 voneinander unterschiedliche Kennungen aussenden. Zur Identifizierung des Ladekabels 4 können die Erkennungsmittel 26 auch eine Kennung des Ladekabels 4 tragen. Dadurch kann die Leseeinrichtung 8a auch erkennen, welches Ladekabel 4 um den Ladekabelhalter 6 gewickelt ist. Dies ist insbesondere bei einer Anordnung gemäß Fig. 4 sinnvoll, bei dem mehr als ein Ladekabel 4 an der Ladestation 2 angeordnet ist. Hierdurch kann verhindert werden, dass ein Ladekabel 4 an einem falschen Ladekabelhalter 6 aufgewickelt wird.

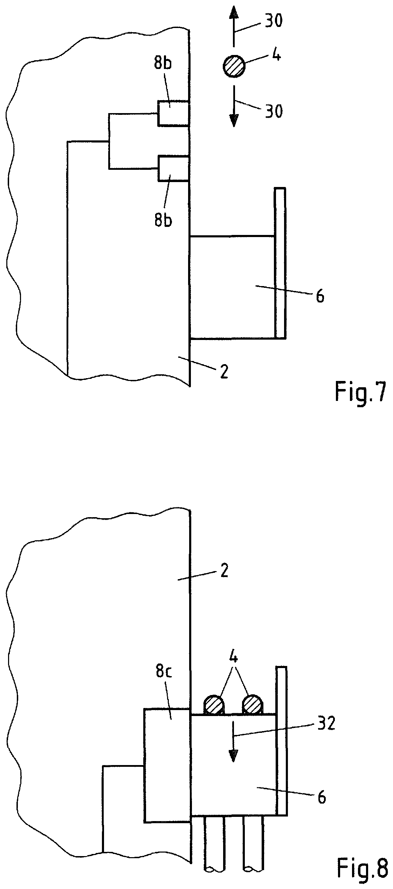

Fig. 7 zeigt ein weiteres Beispiel einer Überwachungseinrichtung 8 die aus zwei nebeneinander angeordneten Näherungssensoren 8b innerhalb der Ladestation 2 gebildet ist. Die Näherungssensoren 8b können erkennen, wenn sich das Ladekabel 4 ihnen nähert. Durch die Anordnung der Näherungssensoren 8b nebeneinander kann eine Bewegung des Ladekabels 4 in der Richtung 30 erkannt werden. Hierdurch ist es möglich, zu erkennen, ob das Ladekabel 4 auf den Ladekabelhalter 6 aufgelegt wird oder von dem Ladekabelhalter 6 abgezogen wird. Wird das Ladekabel 4 nach unten auf den Ladekabelhalter 6 bewegt, so detektierten dies die Näherungssensoren 8b nacheinander und es kann darauf geschlossen werden, dass das Ladekabel 4 in den Ladekabelhalter 6 gelegt wurde.

Ist es beispielsweise notwendig, dass das Ladekabel 4 in zwei Schlaufen um den Ladekabelhalter 6 gelegt wird, ist es notwendig, dass die Näherungssensoren 8b genau zwei mal erkennen, dass ein Ladekabel 4 in Richtung 30 nach unten auf den Ladekabelhalter 6 bewegt wurde. Eine entsprechende Signalisierung erfolgt von der den Näherungssensoren 8b an den Prozessor 10.

Fig. 8 zeigt ein weiteres Ausführungsbeispiel, bei dem die Überwachungseinrichtung 8 eine Wiegeeinrichtung 8c aufweist. Mit Hilfe der Wiegeeinrichtung 8c kann die Gewichtskraft des Ladekabelhalters 6 zusammen mit dem darauf abgelegten Ladekabel 4 gemessen werden. Das Ladekabel 4 übt eine Kraft in Richtung 32 aus. Ist das Ladekabel 4 vollständig um den Ladekabelhalter 6 gewickelt und liegt es nicht mehr auf dem Boden, so wirkt die gesamte Gewichtskraft (abzüglich der Haltekraft an dem Anschlagspunkt des Ladekabels 4 an der Ladestation 2) des Ladekabels 4 auf den Ladekabelhalter 6. Dieses Gewicht ist höher, als beispielsweise das Gewicht, wenn der Ladekabelhalter 6 kein Ladekabel 4 trägt oder das Ladekabel 4 zu einem Teil auf dem Boden liegt. Hierdurch kann die Wiegeeinrichtung 8c durch Vergleich des gemessenen Gewichtes mit einem Grenzwert erkennen, ob das Ladekabel 4 vollständig um den Ladekabelhalter 6 gewickelt wurde. Auch hier erfolgt eine entsprechende Signalisierung gegenüber dem Prozessor 10.

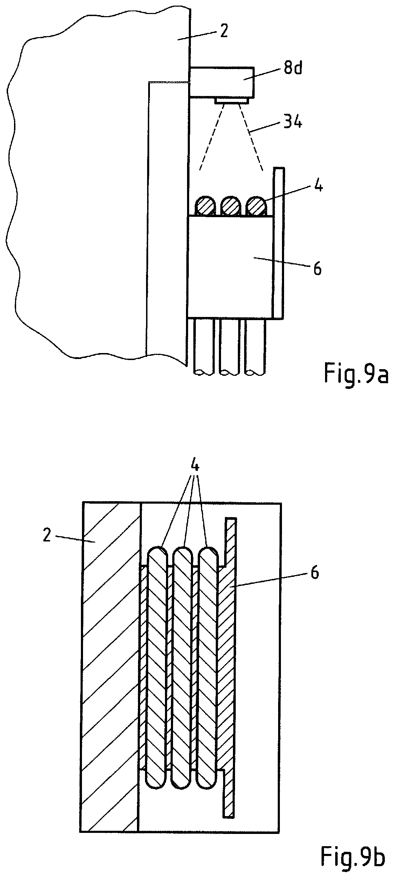

Fig. 9a zeigt ein weiteres Ausführungsbeispiel, bei dem die Überwachungseinrichtung eine Kamera 8d aufweist. Die Kamera 8d kann in Blickrichtung 34 ein Bild aufnehmen. Dieses Bild umfasst unter anderem den Ladekabelhalter 6 und gegebenenfalls das um den Ladekabelhalter 6 gelegte Ladekabel 4. Ein entsprechendes Bild ist in der Fig. 9b dargestellt.

Fig. 9b zeigt ein Bild der Kamera 8d. Auf dem Bild ist das Ladekabel 4 zu erkennen, welches in drei Wicklungen um den Ladekabelhalter 6 gewickelt ist. Ferner ist die Außenwand des Gehäuses der Ladestation 2 zu erkennen. Durch geeignete Mustererkennung an dem Bild gemäß Fig. 9b kann das Ladekabel 4 erkannt werden. Ferner kann erkannt werden, wie oft das Ladekabel 4 um den Ladekabelhalter 6 gewickelt wurde. Dies kann ein Maß dafür sein, ob das Ladekabel 4 korrekt um den Ladekabelhalter 6 gewickelt wurde und entsprechend kann die Kamera 8d ein Signal an den Prozessor 10 übermitteln.

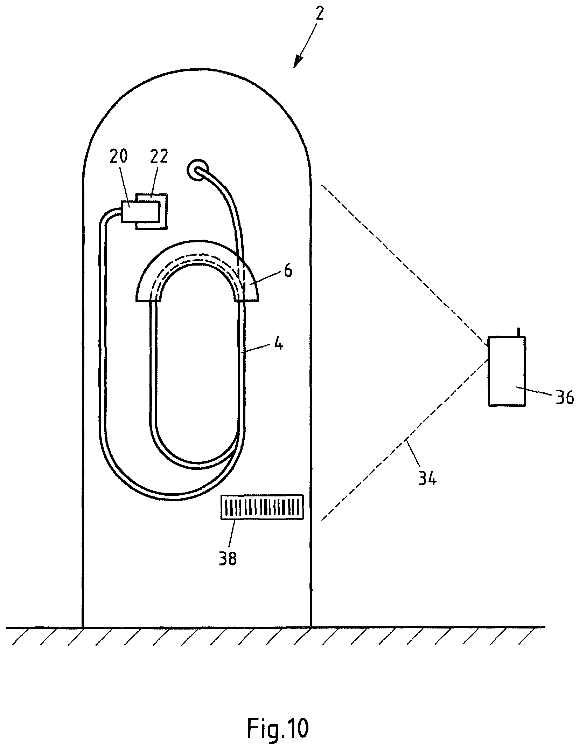

Fig. 10 zeigt ein weiteres Ausführungsbeispiel, bei dem die Ladestation 2 durch ein externes mobiles Gerät 36 erfasst wird. In dem mobilen Gerät 36, beispielsweise einem Mobilfunkgerät oder einem anderen mobilen Kommunikationsgerät, ist eine Kamera vorgesehen. Mit Hilfe der Kamera kann in Blickrichtung 34 ein Bild der Ladestation 2 aufgenommen werden. In diesem Bild ist das Gehäuse der Ladestation 2 sowie das Ladekabel 4 und der Ladekabelhalter 6 zu erkennen. Ferner ist es vorteilhaft, wenn in dem Bild eine optische Codierung 38 beispielsweise in Form eines Barcodes, einer Farbcodierung, eines QR Codes oder dergleichen zu erkennen ist.

Das von dem mobilen Gerät 36 erfasste Bild kann über eine Weitverkehrsverbindung, beispielsweise eine Mobilfunkverbindung und/oder das Internet an einen Server (nicht gezeigt) übermittelt werden. Das Bild kann durch eine mobile Applikation in dem mobilen Gerät 36 erfasst werden. Die mobile Applikation kann dazu programmiert sein, zumindest Teile des zuvor beschriebenen Verfahrens auszuführen, insbesondere die Erkennung der Ladestation 2 bzw. des Ladekabels 4 an dem Ladekabelhalter 6 zu unterstützen.

Das Bild wird in dem mobilen Gerät 36 oder dem Server derart ausgewertet, dass zunächst erkannt wird, wo in dem Bild der Ladekabelhalter 6 ist. Dann wird erkannt, wo das Ladekabel 4 ist. Dies ist insbesondere dann einfach, wenn das Ladekabel 4 sich im Kontrast und/oder der Farbe von dem Ladekabelhalter 6 und der Ladestation 2 abhebt. Auch ist es möglich, dass lediglich die Lage des Ladekabels 4 an der Ladestation 2 ohne Detektion des Ladekabelhalters 6 erkannt wird. Durch Mustererkennung kann erkannt werden, dass das Ladekabel 4 vollständig aufgewickelt ist und insbesondere kann auch erkannt werden, dass der Ladestecker 20 in der Halterung 22 befestigt ist.

Darüber hinaus kann durch die optische Codierung 38 die Ladestation 2 identifiziert werden. Hierdurch kann der Nutzer durch Verwendung der mobilen Applikation in dem mobilen Gerät 36 gegenüber dem Dienstleister nachweisen, dass er das Ladekabel 4 zu einem bestimmten Zeitpunkt korrekt auf die Ladestation 2 aufgewickelt hat. Ist dies in dem Server erkannt worden, kann der Nutzer mit einem Bonus hierfür belohnt werden.

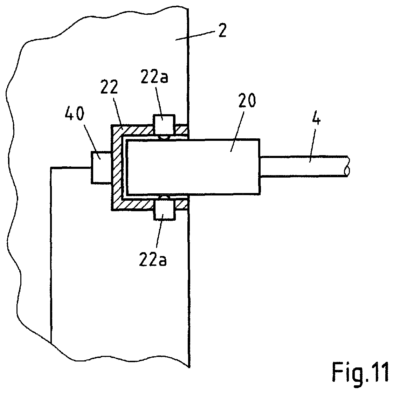

Fig. 11 zeigt ein Ausführungsbeispiel einer Halterung 22 für einen Ladekabelstecker 20. Das Ladekabel 4 hat an seinem Ende 4a den Ladekabelstecker 20. Dieser kann in einer Ausnehmung in dem Gehäuse 2, welche die Halterung 22 bildet, gesteckt werden. In der Halterung 22 können Haltemittel 22a, beispielsweise federkraftgetriebene Haltemittel, den Ladekabelstecker 20 verliersicher verriegeln. Dann ist es notwendig, den Ladekabelstecker 20 mit einer definierten Kraft aus der Halterung 22 herauszuziehen. Ferner ist in der Halterung 22 eine Prüfeinrichtung 40 vorgesehen. Mit Hilfe der Prüfeinrichtung 40 kann geprüft werden, ob das Ladekabel 4 bzw. der Ladekabelstecker 20 in die Halterung 22 eingesteckt wurde. Eine entsprechende Signalisierung kann an den Prozessor 10 erfolgen.

Die Ladestation 2 wird nun wie folgt betrieben. Ein Nutzer beginnt einen Ladevorgang, indem er den Ladestecker 20 in die Ladebuchse seines Fahrzeugs einsteckt und den Ladevorgang freigibt. Der Ladevorgang wird zwischen der Ladeelektronik 18 und einem Laderegler innerhalb des Fahrzeugs gesteuert. Das Ende des Ladevorgangs wird durch die Ladeelektronik 18 detektiert. Außerdem wird durch die Ladeelektronik 18 detektiert, dass der Ladestecker 20 von dem Elektrofahrzeug abgezogen wurde. Dieser Zeitpunkt ist maßgeblich für den Zeitraum, innerhalb dessen die Überwachungseinrichtung 8 das Auflegen des Ladekabels 4 auf den Ladekabelhalter 6 überwachen muss. Es ist erkannt worden, dass nicht immer das Ende des Ladevorgangs mit dem Zeitpunkt korreliert, zu dem das Ladekabel 4 zurück an die Ladestation 2 gelegt wird. Vielmehr ist dies der Zeitpunkt, zu dem das Ladekabel 4 aus der entsprechenden Buchse des Fahrzeugs abgezogen wird. Dieser Zeitpunkt wird von der Ladeelektronik 18 dem Prozessor 10 mitgeteilt und kann auch als das Ende des Ladevorgangs verstanden werden.

Der Prozessor 10 aktiviert daraufhin für einen definierten Zeitraum, beispielsweise fünf Minuten, die Überwachungseinrichtung 8. Die Überwachungseinrichtung 8 aktiviert nunmehr die Leseeinrichtung 8a, den Näherungssensor 8b, die Wiegeeinrichtung 8c, die Kamera 8d und/oder dergleichen. Diese detektieren, wie zuvor beschrieben, ob das Ladekabel 4 korrekt auf den Ladekabelhalter 6 gelegt wird.

Ferner initiiert der Prozessor 10 über die Ladeelektronik 18 eine elektrische Überprüfung des Ladekabels 4. Hierbei kann insbesondere der Isolationswiderstand zwischen den jeweiligen Leitungen/ Adern in dem Ladekabel 4 gemessen werden. Die Ladeelektronik 18 meldet dem Prozessor 10, dass der Isolationswiderstand jeweils innerhalb von vorgegebenen Grenzwerten liegt.

Ferner meldet die Überwachungseinrichtung 8 dem Prozessor 10, wenn das Ladekabel 4 korrekt auf den Ladekabelhalter 6 gelegt wurde. Abschließend kann auch noch die Prüfeinrichtung 40 an den Prozessor 10 melden, ob der Ladekabelstecker 20 korrekt in der Halterung 22 arretiert wurde.

Liegen alle positiven Signale in dem Prozessor 10 vor, kann der Prozessor 10 ein entsprechendes Signal an einen Server übermitteln, so dass ein Bonussystem ausgelöst werden kann.

Auch ist es möglich, dass die Einrichtung 8a - d ihre Messwerte an den Prozessor 10 übermitteln und dieser die empfangenen Messwerte mit in dem Speicher 12 gespeicherten Messwerten vergleicht. Der Vergleich kann in dem Prozessor 10 abgeschlossen werden und somit kann der Prozessor 10 anhand der erfassten Messwerte feststellen, ob das Ladekabel 4 korrekt auf den Ladekabelhalter 6 aufgelegt wurde.

Mit Hilfe der gegenständlichen Ladestation 2 ist es nunmehr möglich, sicherzustellen, dass ein Ladekabel 4 auch korrekt auf einem Ladekabelhalter 6 aufgewickelt worden ist und somit das Unfallrisiko durch liegengebliebene Ladekabel 4 verringert wird.

### Bezugszeichenliste

- 2: Ladestation
- 4: Ladekabel
- 4a: freies Ende
- 6: Ladekabelhalter
- 8: Überwachungseinrichtung
- 8a: Leseeinrichtung
- 8b: Näherungssensor
- 8c: Wiegeeinrichtung
- 8d: Kamera
- 10: Prozessor
- 12: Speicher
- 14: Verteilnetz
- 16: Anschlusselektrik
- 18: Ladeelektronik
- 20: Ladestecker
- 22: Halterung
- 24: Abstand
- 26: Erkennungsmittel
- 28: Abfragefeld
- 30: Richtung
- 32: Richtung
- 34: Blickrichtung
- 36: mobiles Gerät
- 38: optische Kodierung
- 40: Prüfeinrichtung

## Patentansprüche

1. Ladestation (2), insbesondere Ladestation für Elektrofahrzeuge, die Ladestation mit
- einem fest an der Ladestation (2) angeschlagenen Ladekabel (4),
- zumindest einem an der Ladestation (2) angeordneten Ladekabelhalter (6) und
- zumindest einer Überwachungseinrichtung (8) eingerichtet zur Überwachung der Lage des Ladekabels (4) an der Ladestation (2), wobei die Überwachungseinrichtung (8) überwacht, ob das Ladekabel (4) in zumindest einer Schlaufe um den Ladekabelhalter (6) gelegt ist,
**dadurch gekennzeichnet,**
**dass** die Überwachungseinrichtung (8) nach einer Montage des Ladekabels (4) derart an das Ladekabel (4) angelernt ist, dass Messwerte der Überwachungseinrichtung (8) aufgenommen sind, wenn das Ladekabel (4) in zumindest einer Schlaufe um den Ladekabelhalter (6) gelegt ist, und die aufgenommenen Messwerte als Grenzwerte für die Bestimmung, ob das Ladekabel (4) in zumindest einer Schlaufe um den Ladekabelhalter (6) gelegt ist, gespeichert sind.

2. Ladestation nach Anspruch 1,
**dadurch gekennzeichnet,**
- **dass** die Überwachungseinrichtung (8) eine optische Leseeinrichtung (d) aufweist, wobei die optische Leseeinrichtung (8d) zum optischen Erkennen des an dem Ladekabelhalter (6) angeordneten Ladekabels (4) eingerichtet ist, um zu überwachen, ob das Ladekabel (4) in zumindest einer Schlaufe um den Ladekabelhalter (6) gewickelt ist.

3. Ladestation nach einem der vorangehenden Ansprüche,
**dadurch gekennzeichnet,**
- **dass** an dem Ladekabel (4) zumindest zwei optische Erkennungsmittel (26) in Abständen zueinander angeordnet sind, wobei die Erkennungsmittel (26) durch die Überwachungseinrichtung (8) erfassbar sind, insbesondere dass die Überwachungseinrichtung (8) dazu eingerichtet ist, die Erkennungsmittel (26) in einem räumlich begrenzten Bereich zu erfassen, insbesondere dass die Überwachungseinrichtung (8) eine Anzahl und/oder Kennungen von Erkennungsmitteln (26) speichert, welche repräsentativ für das Wickeln des Ladekabels (4) um den Ladekabelhalter (8) sind.

4. Ladestation nach einem der vorangehenden Ansprüche,
**dadurch gekennzeichnet,**
- **dass** in der Ladestation (2) eine Ladeelektronik (18) angeordnet ist, dass die Ladeelektronik (18) zur Erkennung eines Endes eines Ladevorgangs eingerichtet ist und dass die Ladeelektronik (18) beim Erkennen eines Endes eines Ladevorgangs die Überwachungseinrichtung (8) für zumindest einen definierten Zeitraum aktiviert.

5. Ladestation nach Anspruch 4,
**dadurch gekennzeichnet,**
- **dass** die Überwachungseinrichtung (8) nach Aktivierung durch die Ladeelektronik (18) für den definierte Zeitraum überwacht, ob das Ladekabel (4) in zumindest einer Schlaufe um den Ladekabelhalter (6) gewickelt ist und
- **dass** die Überwachungseinrichtung (8) ein Bestätigungssignal ausgibt, wenn innerhalb des definierten Zeitraums detektiert wurde, dass das Ladekabel (4) um den Ladekabelhalter (6) gewickelt ist und
- **dass** die Überwachungseinrichtung (8) am Ende des definierten Zeitraums, ohne dass detektiert wurde, dass das Ladekabel (4) um den Ladekabelhalter (6) gewickelt wurde, ein Fehlersignal ausgibt.

6. Ladestation nach Anspruch 5,
**dadurch gekennzeichnet,**
- **dass** die Überwachungseinrichtung (8) nach Aktivierung durch die Ladeelektronik (18) den elektrischen Zustand des Ladekabels (4) überwacht, insbesondere einen Isolationswiderstand zwischen zumindest jeweils zwei Leitern des Ladekabels (4) misst und mit einem Grenzwert vergleicht,
- **dass** die Überwachungseinrichtung (8) ein Bestätigungssignal ausgibt, wenn innerhalb des definierten Zeitraums detektiert wurde, dass der elektrische Zustand des Ladekabels (4) positiv überwacht wurde und
- **dass** die Überwachungseinrichtung am Ende des definierten Zeitraums, wenn der elektrische Zustand des Ladekabels (4) negativ überwacht wurde, ein Fehlersignal ausgibt.

7. Ladestation nach einem der vorangehenden Ansprüche,
**dadurch gekennzeichnet,**
- **dass** eine Aufnahmebuchse (22) für einen Ladekabelstecker (20) des Ladekabels (4) vorgesehen ist, wobei in der Aufnahmebuchse (22) eine Prüfeinrichtung eingerichtet zum Prüfen der Anwesenheit des Ladekabelsteckers (20) in der Aufnahmebuchse (22) angeordnet ist, insbesondere dass die Prüfeinrichtung einen Endlageschalter, einen Hall-Sensor und/oder einen Mikroschalter aufweist.

8. Ladestation nach Anspruch 7,
**dadurch gekennzeichnet,**
- **dass** die Prüfeinrichtung beim Erkennen der Anwesenheit des Ladekabelsteckers (20) ein Bestätigungssignal ausgibt und
- **dass** ein Prozessor in der Ladestation (2) ein Bestätigungssignal der Prüfeinrichtung überwacht und beim Empfang des Bestätigungssignals innerhalb eines definierten Zeitfensters ein Freigabesignal ausgibt.

9. Ladestation nach einem der vorangehenden Ansprüche,
**dadurch gekennzeichnet,**
- **dass** ein Prozessor in der Ladestation (28) ein Bestätigungssignal der Überwachungseinrichtung (8) überwacht und beim Empfang des Bestätigungssignals innerhalb eines definierten Zeitfensters ein Freigabesignal ausgibt.

10. Ladestation nach Anspruch 1,
**dadurch gekennzeichnet,**
- **dass** die Überwachungseinrichtung (8) eine Wiegeeinrichtung (8c) aufweist, wobei die Wiegeeinrichtung (8c) zum Wiegen des an dem Ladekabelhalter (6) angeordneten Ladekabels (4) eingerichtet ist, um zu überwachen, ob das Ladekabel (4) in zumindest einer Schlaufe um den Ladekabelhalter (6) gewickelt ist.

11. Verfahren zur Überwachung eines Ladekabels an einer Ladestation nach einem der Ansprüche 1 bis 10, wobei das Ladekabel (4) fest an der Ladestation (2) angeschlagen ist, bei dem
- mit Hilfe einer Überwachungseinrichtung (8) überwacht wird, ob das Ladekabel (4) in zumindest einer Schlaufe um den Ladekabelhalter (6) gelegt ist
**dadurch gekennzeichnet,**
- **dass** die Überwachungseinrichtung (8) bei einer Montage des Ladekabels (4) derart an das Ladekabel (4) angelernt wird, dass Messwerte der Überwachungseinrichtung (8) aufgenommen werden, wenn das Ladekabel (4) in zumindest einer Schlaufe um den Ladekabelhalter (6) gelegt wird und die aufgenommenen Messwerte als Grenzwerte für die Bestimmung, ob das Ladekabel (4) in zumindest einer Schlaufe um den Ladekabelhalter (6) gelegt ist, gespeichert werden.

12. Verfahren nach Anspruch 11,
**dadurch gekennzeichnet,**
- **dass** zur Erkennung, ob das Ladekabel (4) in zumindest einer Schlaufe um den Ladekabelhalter (6) gelegt ist, Messwerte der Überwachungseinrichtung (8) mit zuvor bestimmten Grenzwerten verglichen werden.

13. Verfahren nach einem der vorangehenden Ansprüche 11 oder 12,
**dadurch gekennzeichnet,**
- **dass** zur Erkennung, ob das Ladekabel (4) in zumindest einer Schlaufe um den Ladekabelhalter (6) gelegt, zunächst ein Bild der Ladestation (2) erfasst wird, in dem erfassten Bild eine Mustererkennung derart durchgeführt wird, dass der Ladekabelhalter (6) und das Ladekabel (4) erkannt wird und die Position des Ladekabels (4) zu dem Ladekabelhalter (6) in dem Bild bestimmt wird.

14. Verfahren nach Anspruch 13,
**dadurch gekennzeichnet,**
- **dass** in dem Bild der Ladestation (2) ein optisches Erkennungsmittel der Ladestation, insbesondere ein QR Code, erfasst wird und dass mit Hilfe des optischen Erkennungsmittels detektiert wird, welche Ladestation (2) auf dem Bild erfasst ist.

15. System mit einer Ladestation nach einem der Ansprüche 2 bis 9, bei dem die Überwachungseinrichtung (8) durch ein von der Ladestation (2) abgesetztes mobiles Kommunikationsgerät gebildet ist und das mobile Kommunikationsgerät die optische Leseeinrichtung bildet.

## Claims

1. Charging station (2), in particular charging station for electric vehicles the charging station with
- a charging cable (4) firmly attached to the charging station (2),
- at least one charging cable holder (6) arranged on the charging station (2) and
- at least one monitoring device (8) arranged for monitoring the position of the charging cable (4) at the charging station (2), wherein the monitoring device (8) monitors whether the charging cable (4) is laid in at least one loop around the charging cable holder (6),
**characterized in that**,
the monitoring device (8) is trained to the charging cable (4) after the charging cable (4) has been mounted in such a way that measured values of the monitoring device (8) are recorded when the charging cable (4) is laid in at least one loop around the charging cable holder (6), and the recorded measured values are stored as limit values for determining whether the charging cable (4) is laid in at least one loop around the charging cable holder (6).

2. Charging station according to claim 1,
**characterized in that**,
- the monitoring device (8) has an optical reading device (d), the optical reading device (8d) being arranged for optical recognition of the charging cable (4) arranged on the charging cable holder (6) in order to monitor whether the charging cable (4) is laid in at least one loop around the charging cable holder (6).

3. Charging station according to one of the preceding claims,
**characterized in that**,
- at least two optical detection means (26) are arranged at intervals from one another on the charging cable (4), the detection means (26) being detectable by the monitoring device (8), in particular **in that** the monitoring device (8) is arranged to detect the detection means (26) in a spatially limited area, in particular **in that** the monitoring device (8) stores a number and/or identifiers of detection means (26) which are representative of the winding of the charging cable (4) around the charging cable holder (6).

4. Charging station according to one of the preceding claims,
**characterized in that**,
- an electronic charging device (18) is arranged in the charging station (2), **in that** the electronic charging device (18) is arranged to detect an end of a charging process, and **in that** the electronic charging device (18) activates the monitoring device (8) for at least a defined period of time when an end of a charging process is detected.

5. Charging station according to claim 4,
**characterized in that**,
- the monitoring device (8) monitors, after activation by the electronic charging device (18) for the defined period of time, whether the charging cable (4) is laid in at least one loop around the charging cable holder (6), and
- the monitoring device (8) outputs a confirmation signal if it is detected within the defined period of time that the charging cable (4) is laid around the charging cable holder (6), and
- the monitoring device (8) outputs an error signal at the end of the defined period of time without it being detected that the charging cable (4) has been laid around the charging cable holder (6).

6. Charging station according to claim 5,
**characterized in that**,
- the monitoring device (8) monitors the electrical state of the charging cable (4) after activation by the electronic charging device (18), in particular measures an insulation resistance between at least two conductors of the charging cable (4) in each case and compares it with a limit value,
- the monitoring device (8) outputs a confirmation signal if it is detected within the defined period of time that the electrical state of the charging cable (4) has been positively monitored, and
- the monitoring device outputs an error signal at the end of the defined period of time when the electrical state of the charging cable (4) has been monitored negatively.

7. Charging station according to one of the preceding claims,
**characterized in that**,
- a receiving socket (22) is provided for a charging cable plug (20) of the charging cable (4), wherein a testing device arranged for testing the presence of the charging cable plug (20) in the receiving socket (22) is arranged in the receiving socket (22), in particular **in that** the testing device has a limit position switch, a Hall sensor and/or a microswitch.

8. Charging station according to claim 7,
**characterized in that**,
- the testing device emits an acknowledgement signal when it detects the presence of the charging cable plug (20), and
- a processor in the charging station (2) monitors an acknowledgement signal from the test device and outputs an enable signal when the acknowledgement signal is received within a defined period of time.

9. Charging station after one of the preceding claims,
**characterized in that**,
- a processor in the charging station (2) monitors an acknowledgement signal of the monitoring device (8) and outputs an enable signal when the acknowledgement signal is received within a defined period of time.

10. Charging station according to claim 1,
**characterized in that**,
- the monitoring device (8) comprises a weighing device (8c), wherein the weighing device (8c) is arranged for weighing the charging cable (4) arranged on the charging cable holder (6) in order to monitor whether the charging cable (4) is laid in at least one loop around the charging cable holder (6).

11. Method for monitoring a charging cable at a charging station according to any one of claims 1 to 10, wherein the charging cable (4) is firmly attached to the charging station (2), wherein
- a monitoring device (8) is used to monitor whether the charging cable (4) is laid in at least one loop around the charging cable holder (6)
**characterized in that**,
- the monitoring device (8) is trained to the charging cable (4) during assembly of the charging cable (4) in such a way that measured values of the monitoring device (8) are recorded when the charging cable (4) is laid in at least one loop around the charging cable holder (6) and the recorded measured values are stored as limit values for determining whether the charging cable (4) is laid in at least one loop around the charging cable holder (6).

12. Method according to claim 11,
**characterized in that**,
- in order to detect whether the charging cable (4) is laid in at least one loop around the charging cable holder (6), measured values of the monitoring device (8) are compared with previously determined limit values.

13. Method according to one of the preceding claims 11 or 12,
**characterized in that**,
- in order to identify whether the charging cable (4) is laid in at least one loop around the charging cable holder (6), an image of the charging station (2) is firstly captured, pattern recognition is carried out in the captured image in such a way that the charging cable holder (6) and the charging cable (4) are identified and the position of the charging cable (4) relative to the charging cable holder (6) is determined in the image.

14. Method according to claim 13,
**characterized in that**,
- an optical recognition means of the charging station, in particular a QR code, is detected in the image of the charging station (2), and **in that** the optical recognition means is used to determine which charging station (2) is detected in the image.

15. System with a charging station according to one of preceding claims 1 to 9, in which the monitoring device (8) is formed by a mobile communication device remote from the charging station (2) and the mobile communication device forms the optical reading device.

## Revendications

1. Borne de recharge (2), en particulier borne de recharge pour des véhicules électriques, borne de recharge qui a :
- un câble de charge (4) accroché fixement à la borne de recharge (2),
- au moins un support de câble de charge (6) disposé sur la borne de recharge (2) et
- au moins un dispositif de surveillance (8) mis en place pour assurer la surveillance de la position du câble de charge (4) sur la borne de recharge (2), où le dispositif de surveillance (8) surveille si le câble de charge (4) est placé en formant au moins une boucle autour du support de câble de charge (6),
**caractérisée**
**en ce que** le dispositif de surveillance (8), après un montage du câble de charge (4), est configuré sur le câble de charge (4) de manière telle, que des valeurs de mesure du dispositif de surveillance (8) soient reçues quand le câble de charge (4) est placé en formant au moins une boucle autour du support de câble de charge (6), et les valeurs de mesure reçues sont stockées en mémoire comme des valeurs limites, pour déterminer le fait de savoir si le câble de charge (4) est placé en formant au moins une boucle autour du support de câble de charge (6).

2. Borne de recharge selon la revendication 1, **caractérisée**
- **en ce que** le dispositif de surveillance (8) présente un dispositif de lecture optique (8a), où le dispositif de lecture optique (8a) est mis en place pour la reconnaissance optique du câble de charge (4) disposé sur le support de câble de charge (6), afin de surveiller si le câble de charge (4) est enroulé en formant au moins une boucle autour du support de câble de charge (6).

3. Borne de recharge selon l'une des revendications précédentes,
**caractérisée**
- **en ce qu'**au moins deux moyens de reconnaissance optique (26) sont disposés sur le câble de charge (4) en étant espacés l'un de l'autre, où les moyens de reconnaissance (26) peuvent être détectés par le dispositif de surveillance (8), caractérisée en particulier en ce que le dispositif de surveillance (8) est mis en place dans le but de détecter les moyens de reconnaissance (26) dans une zone spatialement limitée, en particulier en ce que le dispositif de surveillance (8) stocke en mémoire un certain nombre de moyens de reconnaissance (26) et/ou leurs identifiants qui sont représentatifs pour l'enroulement du câble de charge (4) autour du support de câble de charge (6).

4. Borne de recharge selon l'une quelconque des revendications précédentes,
**caractérisée**
- **en ce qu'**une électronique de charge (18) est disposée dans la borne de recharge (2), en ce que l'électronique de charge (18) est conçue pour servir à la détection d'une fin d'un processus de charge, et en ce que l'électronique de charge (18), au moment de la détection d'une fin d'un processus de charge, active le dispositif de surveillance (8) pendant au moins un laps de temps défini.

5. Borne de recharge selon la revendication 4,
**caractérisée**
- **en ce que** le dispositif de surveillance (8), après activation par l'électronique de charge (18) pendant le laps de temps défini, surveille si le câble de charge (4) est enroulé en formant au moins une boucle autour du support de câble de charge (6), et
- **en ce que** le dispositif de surveillance (8) émet un signal de confirmation si, dans les limites du laps de temps défini, il a été détecté que le câble de charge (4) est enroulé autour du support de câble de charge (6), et
- **en ce que** le dispositif de surveillance (8), à la fin du laps de temps défini, sans qu'il ait été détecté que le câble de charge (4) a été enroulé autour du support de câble de charge (6), émet un signal d'erreur.

6. Borne de recharge selon la revendication 5,
**caractérisée**
- **en ce que** le dispositif de surveillance (8), après activation par l'électronique de charge (18), surveille l'état électrique du câble de charge (4), en particulier mesure une résistance d'isolement à chaque fois au moins entre deux conducteurs du câble de charge (4) et compare à une valeur limite,
- **en ce que** le dispositif de surveillance (8) émet un signal de confirmation si, dans les limites du laps de temps défini, il a été détecté que l'état électrique du câble de charge (4) a été surveillé de manière positive, et
- **en ce que** le dispositif de surveillance émet un signal d'erreur à la fin du laps de temps défini, si l'état électrique du câble de charge (4) a été surveillé de manière négative.

7. Borne de recharge selon l'une quelconque des revendications précédentes,
**caractérisée**
- **en ce qu'**il est prévu une douille de réception (22) pour un connecteur de câble de charge (20) du câble de charge (4), où un dispositif de contrôle est mis en place, dans la douille de réception (22), afin d'assurer le contrôle de la présence du connecteur de câble de charge (20) dans la douille de réception (22), caractérisée en particulier en ce que le dispositif de contrôle présente un interrupteur de fin de course, un capteur à effet Hall et/ou un microrupteur.

8. Borne de recharge selon la revendication 7,
**caractérisée**
- **en ce que** le dispositif de contrôle, quand il détecte la présence du connecteur de câble de charge (20), émet un signal de confirmation, et
- **en ce qu'**un processeur placé dans la borne de recharge (2) surveille un signal de confirmation du dispositif de contrôle et, à réception du signal de confirmation se produisant dans les limites d'une fenêtre de temps définie, émet un signal de validation.

9. Borne de recharge selon l'une quelconque des revendications précédentes,
**caractérisée**
- **en ce qu'**un processeur placé dans la borne de recharge (2) surveille un signal de confirmation du dispositif de surveillance (8) et, à réception du signal de confirmation se produisant dans les limites d'une fenêtre de temps définie, émet un signal de validation.

10. Borne de recharge selon la revendication 1,
**caractérisée**
- **en ce que** le dispositif de surveillance (8) présente un dispositif de pesage (8c), où le dispositif de pesage (8c) est mis en place pour peser le câble de charge (4) disposé sur le support de câble de charge (6), afin de surveiller si le câble de charge (4) est enroulé en formant au moins une boucle autour du support de câble de charge (6).

11. Procédé permettant la surveillance d'un câble de charge placé sur une borne de recharge selon l'une quelconque des revendications 1 à 10, où le câble de charge (4) est accroché fixement à la borne de recharge (2), procédé dans lequel,
- à l'aide d'un dispositif de surveillance (8), on surveille si le câble de charge (4) est placé en formant au moins une boucle autour du support de câble de charge (6),
**caractérisé**
- **en ce que** le dispositif de surveillance (8), lors d'un montage du câble de charge (4), est configuré sur le câble de charge (4) de manière telle, que des valeurs de mesure du dispositif de surveillance (8) soient reçues quand le câble de charge (4) est placé en formant au moins une boucle autour du support de câble de charge (6), et les valeurs de mesure reçues sont stockées en mémoire comme des valeurs limites, pour déterminer le fait de savoir si le câble de charge (4) est placé en formant au moins une boucle autour du support de câble de charge (6).

12. Procédé selon la revendication 11,
**caractérisé**
- **en ce que**, pour la détection du fait de savoir si le câble de charge (4) est placé en formant au moins une boucle autour du support de câble de charge (6), des valeurs de mesure du dispositif de surveillance (8) sont comparées à des valeurs limites préalablement déterminées.

13. Procédé selon l'une des revendications précédentes 11 ou 12,
**caractérisé**
- **en ce que**, pour la détection du fait de savoir si le câble de charge (4) est placé en formant au moins une boucle autour du support de câble de charge (6), une image de la borne de recharge (2) est d'abord saisie, une reconnaissance de formes étant réalisée, dans l'image saisie, de manière telle que le support de câble de charge (6) et le câble de charge (4) soient identifiés et que la position du câble de charge (4), par rapport au support de câble de charge (6), soit déterminée dans l'image.

14. Procédé selon la revendication 13,
**caractérisé**
- **en ce que**, dans l'image de la borne de recharge (2), un moyen de reconnaissance optique, en particulier un code QR, est saisi, et en ce que, à l'aide du moyen de reconnaissance optique, on détecte quelle borne de recharge (2) est saisie sur l'image.

15. Système comprenant une borne de recharge selon l'une quelconque des revendications 2 à 9, système dans lequel le dispositif de surveillance (8) est formé par un appareil de communication mobile situé à distance de la borne de recharge (2), et système dans lequel l'appareil de communication mobile forme le dispositif de lecture optique.
